# EUROPÄISCHE PATENTSCHRIFT

(11) **EP 1 786 107 B1**
(45) Veröffentlichungstag und Bekanntmachung des Hinweises auf die Patenterteilung: **03.03.2010**
(21) Anmeldenummer: 06022980.4
(22) Anmeldetag: 04.11.2006
(51) Int. Cl.: H03K 17/96

(54) **Kapazitiver Berührungsschalter**
Capacitive touch-sensitive switch
Commutateur tactile capacitif

(30) Priorität: 09.11.2005 DE 102005053792
(43) Veröffentlichungstag der Anmeldung: 16.05.2007
(73) Patentinhaber: Diehl AKO Stiftung & Co. KG, 88239 Wangen (DE)
(72) Erfinder: Heimann, Uwe, 90427 Nürnberg (DE); Prinz, Michael, 88299 Leutkirch (DE)
(74) Vertreter: Diehl Patentabteilung

(56) Entgegenhaltungen:
- EP-A1- 0 780 865
- EP-A1- 0 858 166
- DE-A1- 3 245 803
- DE-A1-102005 041 111
- DE-U1-202005 002 157
- FR-A1- 2 704 332

## Beschreibung

Die vorliegende Erfindung betrifft einen kapazitiven Berührungsschalter nach dem Oberbebgriff des Anspruchs 1.

In vielen elektrischen Geräten, insbesondere auch in Haushaltsgeräten wie Herden, Kochfeldern, Mikrowellenöfen, Spülmaschinen, Waschmaschinen und dergleichen, werden immer häufiger Berührungsschalter eingesetzt, die durch ein einfaches Berühren durch einen Benutzer einen bestimmten Schaltvorgang auslösen. Im Fall eines kapazitiven Berührungsschalters bildet ein kapazitives Sensorelement zu-, sammen mit dem Finger eines Benutzers über ein als Dielektrikum wirkendes Berührungsfeld eine Kapazität, die entsprechend dem Betätigen des Berührungsschalters, d.h. dem Berühren oder Nicht-Berühren eines dem kapazitiven Sensorelement zugeordneten Berührungsfeldes variabel ist. Die Veränderung der Kapazität des kapazitiven Sensorelements durch eine Berührung durch den Benutzer wirkt sich entsprechend auf ein Ausgangssignal der Sensorschaltung aus, was von einer angeschlossenen Auswerteschaltung entsprechend als eine Betätigung des kapazitiven Berührungsschalters ausgewertet wird. Ein derartiger kapazitiver Berührungsschalter ist zum Beispiel aus der DE 32 45 803 A1 bekannt.

Ferner offenbart die DE 20 2005 002 157 U1 ein kapazitives Sensorelement für einen Berührungsschalter der oben angegebenen Art, das aus einer elektrisch leitenden Druckfeder gebildet ist, deren dem Berührungsfeld zugewandtes Ende erweitert ist. Die Druckfeder ist mechanisch und elektrisch mit einer Leiterplatte zum Beispiel mittels Löten verbunden. Ein solches kapazitives Sensorelement gewährleistet einerseits einen guten Kontakt zwischen dem Sensorelement und dem Berührungsfeld und bietet andererseits einen erweiterten sensitiven Bereich. Nachteilig bei diesem kapazitiven Sensorelement ist allerdings seine komplizierte Form aufgrund des Erweiterungsbereichs.

Das US-Patent Nr. 5,917 165 beschreibt ein Sensorelement für einen kapazitiven Berührungsschalter, der aus einem elektrisch leitfähigen, elastischen Schaumstoff-, Kunststoff- oder Gummikörper gebildet ist. Ein solches Sensorelement zeichnet sich durch seinen einfachen Aufbau und seine einfache Montage aus und gewährleistet außerdem einen guten elektrischen Kontakt sowohl zur Leiterplatte als auch zum Berührungsfeld.

Aus der FR 2 704 332 A1 ist ein kapazitiver Berührungsschalter mit einem Berührungsfeld und einer darunter befindlichen Leiterplatte bekannt. Zwischen Berührungsfeld und Leiterplatte steht eine metallische Druckfeder als kapazitives Sensorelement in elektrisch leitendem Kontakt mit diesen und wird von einem zentralen Haltestift geführt.

Es ist eine Aufgabe der vorliegenden Erfindung, einen weiteren kapazitiven Berührungsschalter vorzusehen, der einen guten elektrischen Kontakt zum Berührungsfeld auch bei Temperaturwechseln gewährleistet und trotz seines einfachen Aufbaus variabel einsetzbar ist.

Diese Aufgabe wird durch einen kapazitiven Berührungsschalter mit den Merkmalen des Anspruchs 1 gelöst. Vorteilhafte Ausgestaltungen und Weiterbildungen der Erfindung sind Gegenstand der abhängigen Ansprüche.

Der kapazitive Berührungsschalter weist ein Berührungsfeld mit einer Oberseite und einer Unterseite; einer Leiterplatte, die mit einem Abstand unter der Unterseite des Berührungsfeldes angeordnet ist; und ein kapazitives Sensorelement, das zwischen der Unterseite des Berührungsfeldes und der Leiterplatte angeordnet und mit der Leiterplatte elektrisch leitend in Kontakt ist, auf. Das kapazitive Sensorelement weist seinerseits eine Druckfeder aus einem elektrisch leitenden Material und ein Kontaktelement aus einem elektrisch leitenden Material, das auf der dem Berührungsfeld zugewandten Seite der Druckfeder angeordnet und mit der Druckfeder elektrisch leitend in Kontakt ist, auf, wobei der kapazitive Berührungsschalter ferner einen zentralen Haltestift aufweist, der sich durch das Sensorelement im Wesentlichen über dessen gesamte Höhe erstreckt und der Haltestift integral mit dem Berührungsfeld ausgebildet ist.

Das Kontaktelement kann variabel sowohl an die Form und die Beschaffenheit des Berührungsfeldes als auch an die Form und Größe des dem Benutzer dargebotenen sensitiven Bereichs angepasst werden. Aufgrund des zweiteiligen Aufbaus des Sensorelements ist eine solche Anpassung problemlos möglich, ohne dass ein einziges Bauelement mit Merkmalen bzw. Funktionen überfrachtet wird. Das Kontaktelement kann dabei auch einen relativ großen sensitiven Bereich bilden, ohne dass hierzu Metallisierungen des Berührungsfeldes notwendig wären. Die Druckfeder, die sich gegen die Leiterplatte und das Kontaktelement abstützt, gewährleistet einen zuverlässigen Kontakt zwischen dem Kontaktelement des Sensorelements und der Unterseite des Berührungsfeldes, wodurch die Funktionsfähigkeit des kapazitiven Berührungsschalters auch bei Temperaturänderungen, Alterungsprozessen der Bauelemente, Toleranzen und Positionsungenauigkeiten der Bauelemente und der dergleichen verbessert ist. Auf diesen Haltestift können die Druckfeder und das Kontaktelement aufgeschoben bzw. aufgesteckt werden und so einfach zwischen Leiterplatte und Berührungsfeld positioniert werden. Infolge der integralen Ausbildung des Haltestifts reduziert sich die Anzahl der Bauteile und ermöglicht daher einen verringerten Montageaufwand.

In einer Ausgestaltung der Erfindung kann der Haltestift an seinem der Leiterplatte zugewandten Ende mit einer Rastvorrichtung zur mechanischen Verbindung mit der Leiterplatte versehen sein.

In einer weiteren Ausgestaltung der Erfindung weist das kapazitive Sensorelement ferner auf seiner der Leiterplatte zugewandten Seite ein weiteres Kontaktelement zur elektrischen Kontaktierung mit der Leiterplatte auf.

Dieses weitere Kontaktelement kann mit einer Rastvorrichtung zur mechanischen Verbindung mit der Leiterplatte versehen sein. Weiter können dieses weitere Kontaktelement und die Druckfeder durch eine Lötverbindung miteinander verbunden sein.

In einer alternativen Ausgestaltung der Erfindung ist auf der Leiterplatte ein weiteres Kontaktelement zur elektrischen Kontaktierung mit der Druckfeder vorgesehen, gegen das sich die Druckfeder abstützt.

In einer weiteren Ausgestaltung der Erfindung sind das Kontaktelement und die Druckfeder des Sensorelements durch eine Lötverbindung miteinander verbunden.

In einer noch weiteren Ausgestaltung der Erfindung ist der Haltestift als ein Lichtleitelement ausgebildet, und auf der Leiterplatte ist an einer mittigen Position des Sensorelements ein Leuchtelement wie beispielsweise eine LED angeordnet, sodass das Berührungsfeld für den Benutzer hinterleuchtet werden kann.

In einer alternativen Ausführungsform ohne Haltestift ist auf der Leiterplatte an einer mittigen Position des Sensorelements ein Leuchtelement angeordnet, dem ferner ein zentrales Lichtleitelement zugeordnet sein kann, das sich durch das Sensorelement im Wesentlichen über dessen gesamte Höhe erstreckt.

In einer weiteren alternativen Ausführungsform weist der Berührungsschalter ferner wenigstens ein Leuchtelement neben dem kapazitiven Sensorelement zwischen der Leiterplatte und dem Berührungsfeld auf, um das Berührungsfeld großflächig zu hinterleuchten.

Ferner kann das Berührungsfeld auf seiner Oberseite mit einer Folie versehen sein, die an ihrer dem Berührungsfeld zugewandten Rückseite im Bereich des Kontaktelements des kapazitiven Sensorelements metallisiert ist. Anstelle der Folie ist vorteilhafter Weise ein metallisierter Farbaufdruck verwendbar.

In einer alternativen Ausführungsform kann das Berührungsfeld auf seiner Unterseite mit einer Folie versehen sein, die an ihrer dem Berührungsfeld zugewandten Rückseite im Bereich des Kontaktelements des kapazitiven Sensorelements metallisiert ist. Anstelle der Folie ist vorteilhafter Weise ein metallisierter Farbaufdruck verwendbar.

In einer besonders vorteilhaften Ausführung ist die an der Unterseite des Berührungsfeldes angeordnete Folie bzw. der Farbaufdruck in Kontakt mit einer weiteren Platte, die aus einem anderen Material bestehen kann als das Berührungsfeld.

Obige sowie weitere Merkmale und Vorteile der Erfindung werden aus der nachfolgenden Beschreibung bevorzugter, nicht-einschränkender Ausführungsbeispiele unter Bezugnahme auf die beiliegenden Zeichnungen besser verständlich. Darin zeigen:
- Fig. 1: eine schematische Perspektivansicht eines aufgeschnittenen Bedienfeldes mit mehreren verschiedenen kapazitiven Berührungsschaltern;
- Fig. 2: eine schematische Seitenansicht eines Sensorelements eines kapazitiven Berührungsschalters gemäß einem ersten Beispiel.
- Fig. 3: eine schematische Seitenansicht eines Sensorelements eines kapazitiven Berührungsschalters gemäß einem zweiten Beispiel ;
- Fig. 4: eine schematische Perspektivansicht eines Sensorelements eines kapazitiven Berührungsschalters gemäß einem ersten Ausführungsbeispiel der vorliegenden Erfindung; und
- Fig. 5: eine schematische Perspektivansicht eines aufgeschnittenen kapazitiven Berührungsschalters gemäß einem zweiten Ausführungsbeispiel der vorliegenden Erfindung.

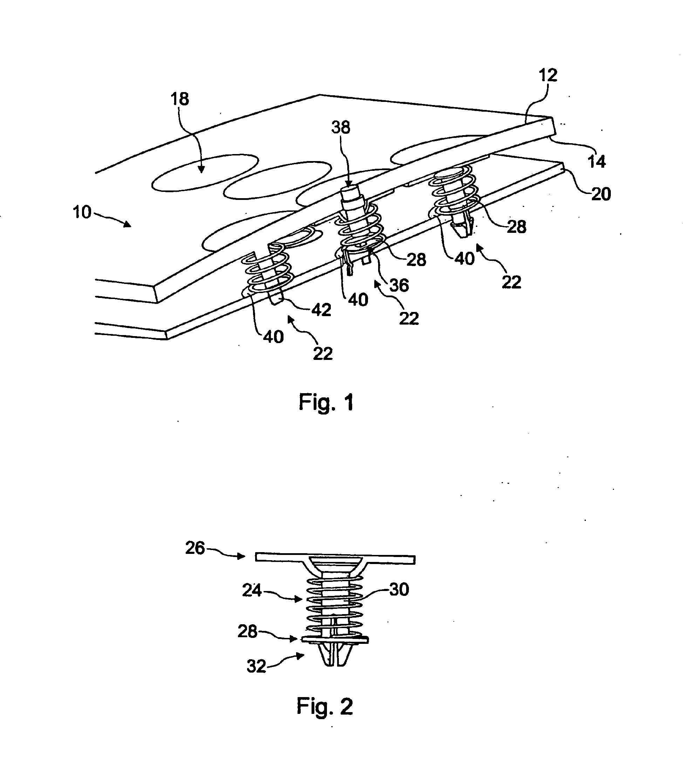

Fig. 1 zeigt einen Ausschnitt eines Bedienfeldes eines elektrischen Geräts, insbesondere eines elektrischen Haushaltsgeräts (Herd, Kochfeld, Mikrowellenofen, Spülmaschine, Waschmaschine und dergleichen) schematisch in Perspektivansicht.

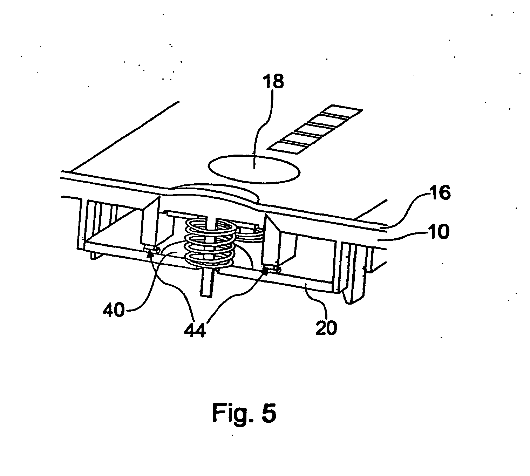

Mit 10 ist ein Berührungsfeld wie beispielsweise eine Kunststoffplatte oder eine Glaskeramikplatte eines Kochfeldes bezeichnet, die eine Oberseite 12 und eine Unterseite 14 besitzt. Auf der Oberseite 12 des Berührungsfeldes 10 ist eine Folie 16 (siehe auch Fig. 5) zum Beispiel mittels IMD- oder IML-Technik aufgebracht, die zur Kennzeichnung der verschiedenen sensitiven Bereiche 18 der einzelnen Berührungsschalter zum Beispiel mit einem (vorzugsweise metallisierten) Farbaufdruck versehen ist. Anstelle der Folie ist auch ein metallisierter Aufdruck einsetzbar.

Es kann aber auch auf der Unterseite 14 des Berührungsfeldes 10 eine Folie 16 (siehe auch Fig. 5) oder ein metallisierter Farbaufdruck zum Beispiel mittels IMD- oder IML-Technik zur Kennzeichnung der verschiedenen sensitiven Bereiche 18 der einzelnen Berührungsschalter aufgebracht sein.

In einem bestimmten Abstand von der Unterseite 14 des Berührungsfeldes 10 ist eine Leiterplatte 20 angeordnet, die mit diversen elektrischen Bauelementen (nicht dargestellt) bestückt ist und insbesondere eine Sensorschaltung und eine Auswerteschaltung für die verschiedenen kapazitiven Berührungsschalter enthält.

In der Darstellung von Fig. 1 sind insgesamt drei unterschiedliche kapazitive Berührungsschalter 22 mit entsprechend unterschiedlichen Sensorelementen veranschaulicht, die nachfolgend anhand der Fig. 2 bis 4 im mehr Einzelheiten erläutert werden.

Der in Fig. 2 (ohne Berührungsfeld 10 und Leiterplatte 20) dargestellte kapazitive Berührungsschalter 22 entspricht der Ausführungsform rechts in Fig. 1.

Das kapazitive Sensorelement dieses Berührungsschalters 22 besteht im Wesentlichen aus einer Druckfeder 24 aus einem elektrisch leitenden Material, einem Kontaktelement 26, das auf der dem Berührungsfeld 10 zugewandten Seite der Druckfeder 24 (oben in Fig. 2) angeordnet ist, aus einem elektrischen leitenden Material, und einem weiteren Kontaktelement 28, das auf der der Leiterplatte 20 zugewandten Seite der Druckfeder 24 (unten in Fig. 2) angeordnet ist, aus einem elektrischen leitenden Material. Das Kontaktelement 26 und das weitere Kontaktelement 28 stehen jeweils mit der Druckfeder 24 elektrisch leitend in Kontakt, die sich gegen diese beiden Kontaktelemente 26, 28 abstützt.

Der kapazitive Berührungsschalter 22 dieses Beispiels enthält ferner einen zentralen Haltestift 30 zum Beispiel aus Kunststoff, der sich im Wesentlichen über die gesamte Höhe des Sensorelements erstreckt und an dessen der Leiterplatte 20 zugewandtem Ende (unten in Fig. 2) eine Rastvorrichtung 32 vorgesehen bzw. integral mit diesem ausgebildet ist. Die Rastvorrichtung 32 ist zum Beispiel in Form einer erweiterten Spitze mit einer zentralen Ausnehmung ausgebildet, sodass die Rastvorrichtung 32 durch ein entsprechendes Montageloch in der Leiterplatte 20 gedrückt und dort festgeklemmt werden kann, wie in Fig. 1 veranschaulicht.

Der zentrale Haltestift 30 dient der Positionierung des Sensorelements des kapazitiven Berührungsschalters 22 auf der Leiterplatte 20. Zur Montage kann entweder das Sensorelement bestehend aus Druckfeder 24, Kontaktelement 26 und weiterem Kontaktelement 28 auf den Haltestift 30 gesetzt und dann diese vormontierte Baugruppe auf der Leiterplatte 20 montiert werden, oder der Haltestift 30 kann zunächst auf der Leiterplatte 20 montiert und dann mit dem Sensorelement bestehend aus Druckfeder 24, Kontaktelement 26 und weiterem Kontaktelement 28 bestückt werden. In jedem Fall ermöglicht der kapazitive Berührungsschalter 22 einen einfachen Montageprozess.

Die beiden Kontaktelemente 26 und 28 sind in Fig. 2 jeweils scheibenförmig dargestellt. Die vorliegende Erfindung ist aber auf keine spezielle Form und Größe dieser Kontaktelemente 26, 28 eingeschränkt; insbesondere das Kontaktelement 26 zum Berührungsfeld 10 kann in seiner Form und Größe dem gewünschten sensitiven Bereich 18 und in seiner Form und Beschaffenheit der Unterseite 14 des Berührungsfeldes 10 angepasst sein. So kann die Kontur des Kontaktelements 26 zum Beispiel kreisförmig, elliptisch, quadratisch, rechteckig, nierenförmig, usw. sein. Der entsprechende sensitive Bereich 18 des kapazitiven Berührungsschalters 22 wird, wie bereits oben erwähnt, dem Benutzer zum Beispiel durch einen Farbaufdruck auf der Folie 16 angezeigt. Selbst erhabene oder vertiefte Bereiche der Unterseite 16 des Berührungsfeldes 10 können durch ein entsprechendes Kontaktelement 26 problemlos adaptiert werden.

Im montierten Zustand, wie er in Fig. 1 rechts gezeigt ist, ist das Sensorelement bestehend aus Druckfeder 24, Kontaktelement 26 und weiterem Kontaktelement 28 des kapazitiven Berührungsschalters 22 zwischen der Unterseite 14 des Berührungsfeldes 10 und der Leiterplatte 20 angeordnet und durch den Haltestift 30 in seiner Position fixiert. Die Druckfeder 24 drückt einerseits das Kontaktelement 26 gegen die Unterseite 14 des Berührungsfeldes 10 und andererseits das weitere Kontaktelement 28 gegen einen entsprechenden elektrischen Kontakt 40 auf der Leiterplatte 20. Hierdurch wird unabhängig von Temperaturschwankungen, Bauteiltoleranzen, Positionsungenauigkeiten und dergleichen immer ein ausreichend guter Kontakt des Sensorelements gewährleistet, wodurch die Funktionsfähigkeit des kapazitiven Berührungsschalters 22 sichergestellt ist.

Während in dem oben beschriebenen ersten Beispiel die Druckfeder 24, das Kontaktelement 26 und das weitere Kontaktelement 28 lose auf den Haltestift 30 gesetzt sind, ist es auch möglich, die Druckfeder 24 und das Kontaktelement 26 und/oder die Druckfeder 24 und das weitere Kontaktelement 28 mittels einer Lötverbindung elektrisch und mechanisch miteinander zu verbinden.

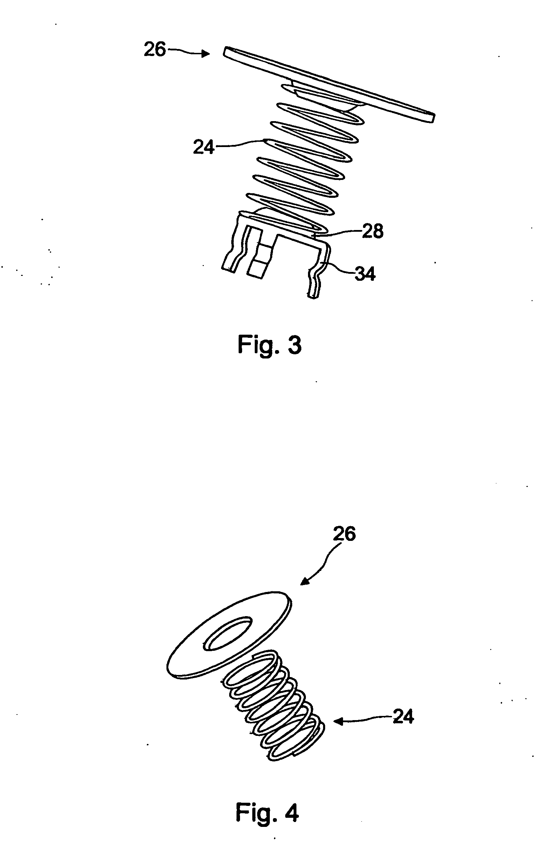

Unter Bezugnahme auf Fig. 1 und 3 wird nun ein zweites Beispiel eines kapazitiven Berührungsschalters 22 näher erläutert.

Wie in Fig. 3 dargestellt, besteht das Sensorelement dieses kapazitiven Berührungsschalters 22 aus einer Druckfeder 24 aus einem elektrisch leitenden Material, einem Kontaktelement 26, das auf der dem Berührungsfeld 10 zugewandten Seite der Druckfeder 24 vorgesehen ist, aus einem elektrisch leitenden Material, und einem weiteren Kontaktelement 28, das auf der der Leiterplatte 20 zugewandten Seite der Druckfeder 24 vorgesehen ist, aus einem elektrisch leitenden Material. Das weitere Kontaktelement 28 weist zudem eine Rastvorrichtung 34 zum Beispiel in Form von Federbeinchen auf, die durch entsprechende Montagelöcher in der Leiterplatte 20 gesteckt und festgeklemmt werden können, wie in Fig. 1 Mitte veranschaulicht.

Da in diesem Beispiel von Fig. 3 und Fig. 1 Mitte im Gegensatz zum oben beschriebenen ersten Ausführungsbeispiel kein zentraler Haltestift 30 zur Positionierung des Sensorelements vorgesehen ist, ist es bevorzugt, die Druckfeder 24 und das Kontaktelement 26 sowie die Druckfeder 24 und das weitere Kontaktelement 28 jeweils miteinander zu verlöten. Außerdem wird die Rastvorrichtung 34 des weiteren Kontaktelements 28 vorzugsweise mit einem entsprechenden elektrischen Kontakt der Leiterplatte 20 verlötet.

Die übrigen Elemente und deren Funktionen und Vorteile entsprechen jenen des ersten Beispiels. Insbesondere gelten hinsichtlich der Ausführungsformen des Kontaktelements 26 die oben in Zusammenhang mit dem Beispiel von Fig. 2 gemachten Bemerkungen. Weiter werden mit dem kapazitiven Berührungsschalter 22 von Fig. 1 Mitte und Fig. 3 die gleichen Wirkungen und Vorteile wie bei dem obigen ersten Beispiel erzielt.

Wie in Fig. 1 Mitte veranschaulicht, kann der kapazitive Berührungsschalter 22 in diesem Fall zusätzlich ein Leuchtelement 36 zum Beispiel in der Form einer Leuchtdiode (LED) aufweisen, das bezüglich des Sensorelements 24-28 mittig auf der Leiterplatte 20 angebracht ist. Mit Hilfe dieser LED 36 kann der sensitive Bereich 18 dieses kapazitiven Berührungsschalters 22 auf einfache Weise für den Benutzer hinterleuchtet werden. Um den Wirkungsgrad der LED 36 bezüglich der Hinterleuchtung des sensitiven Bereichs 18 zu verbessern ist es von Vorteil, wenn der kapazitive Berührungsschalter 22 ferner ein zentrales Lichtleitelement 38 aufweist, das sich durch das Sensorelement 24-28 im Wesentlichen über dessen gesamte Höhe und gegebenenfalls bis in die Unterseite 14 des Berührungsfeldes 10 hinein erstreckt.

Ein erstes Ausführungsbeispiel des kapazitiven Berührungsschälters 22 wird nun anhand von Fig. 4 und Fig. 1 links näher erläutert.

Der kapazitive Berührungsschalter 22 von Fig. 4 besitzt ein Sensorelement bestehend aus einer Druckfeder 24 aus einem elektrisch leitenden Material und einem Kontaktelement 26 aus einem elektrisch leitenden Material, das auf der dem Berührungsfeld 10 zugewandten Seite der Druckfeder 24 angeordnet ist. Im Gegensatz zu den beiden obigen Beispielen weist das Sensorelement dieses kapazitiven Berührungsschalters 22 kein weiteres Kontaktelement 28 auf der der Leiterplatte 20 zugewandten Seite der Druckfeder 24 auf. Stattdessen ist die Leiterplatte 20 selbst mit einem weiteren Kontaktelement 40 in Form einer elektrischen Kontaktfläche versehen, wie in Fig. 1 links dargestellt. Die Druckfeder 24 stützt sich hier gegen das Kontaktelement 26 und gegen das weitere Kontaktelement 40 der Leiterplatte 20 ab.

Wie in Fig. 1 links veranschaulicht, ist ferner ein zentraler Haltestift 42 zum Beispiel aus Kunststoff oder Glaskeramik vorgesehen, der integral mit dem Berührungsfeld 10 ausgebildet ist und sich über die gesamte Höhe des Sensorelements 24-26 bis durch ein entsprechendes Montageloch in der Leiterplatte 20 hindurch erstreckt, um das Sensorelement 24-26 genau zwischen der Leiterplatte 20 und dem Berührungsfeld 10 positionieren zu können. Eine Rastvorrichtung analog dem ersten Ausführungsbeispiel ist hier an dem zentralen Haltestift 42 nicht vorgesehen, kann aber optional ebenfalls vorhanden sein.

Weitere Bauelemente, Merkmale, deren Wirkungen und Vorteile sind gleich jenen des obigen ersten Beispiels. Insbesondere ist es auch hier möglich, die Druckfeder 24 und das Kontaktelement 26 einzeln lose auf den zentralen Haltestift 42 zu setzen oder die Druckfeder 24 und das Kontaktelement 26 miteinander zu verlöten und als eine Einheit auf den zentralen Haltestift 42 zu setzen.

Des Weiteren ist auch eine Kombination des ersten Beispiels und dem ersten Ausführungsbeispiel von Fig. 2 und 4 denkbar. Das heißt, der kapazitive Berührungsschalter 22 enthält ein Sensorelement gemäß Fig. 4 mit einer Druckfeder 24 und einem Kontaktelement 26, ein weiteres Kontaktelement 40 auf der Leiterplatte 20 gemäß Fig. 4 und einen zentralen Haltestift 30 gemäß Fig. 2.

In einer weiteren Alternative von Fig. 4 ist es auch möglich, den zentralen Haltestift 42 als Lichtleitelement auszubilden und auf der Leiterplatte 20 an der entsprechenden Position ein Leuchtelement zum Beispiel in Form einer LED anzuordnen, sodass der sensitive Bereich 18 des Berührungsschalters 22 auf dem Berührungsfeld 10 für den Benutzer analog dem obigen zweiten Ausführungsbeispiel hinterleuchtet werden kann.

Schließlich zeigt Fig. 5 eine schematische Darstellung eines kapazitiven Berührungsschalters 22 eines weiteren Ausführungsbeispiels.

Der Berührungsschalter 22 von Fig. 5 ist im Wesentlichen wie jener des ersten Ausführungsbeispiels von Fig. 4 aufgebaut, die vorliegende Ausführungsform ist aber analog auch auf die anderen beschriebenen Beispielen übertragbar.

Neben dem Sensorelement 24-26 sind auf der Leiterplatte 20 auf zwei Seiten Leuchtelemente 44 bestehend zum Beispiel aus einer LED und einem Lichtleitelement vorgesehen. Auf diese Weise ist es möglich, den sensitiven Bereich 18 des kapazitiven Berührungsschalters 22 auf dem Berührungsfeld 10 großflächig zu hinterleuchten.

Durch die oben beschriebenen und in den Figuren dargestellten kapazitiven Berührungsschalter 22 werden insbesondere die folgenden Vorteile erzielt:
- der gesamte sensitive Bereich 18 des Berührungsfeldes 10 kann in seiner geometrischen Ausprägung durch ein entsprechendes kongruentes Kontaktelement 26 vollständig kontaktierbar nachgebildet werden;
- mechanische Kontaktierungsprobleme zwischen dem Kontaktelement 26 und der Unterseite 14 des Berührungsfeldes 10, wie Toleranzen, Versatz, Positionsungenauigkeiten, Niveauunterschiede und dergleichen, können dauerhaft kompensiert werden;
- das Sensorelement in seiner Gesamtheit lässt sich mit einem einfachen Montageprozess auf der Leiterplatte 20 befestigen bzw. in die Bedienblende montieren und mit der Leiterplatte 20 halten;
- eine mehrteilige Ausbildung des Sensorelements vermeidet eine Funktionsüberfrachtung am einzelnen Bauteil und ermöglicht gleichzeitig eine optimale Anpassung an spezielle geforderte Aufgaben;
- ein elektrisch leitfähiger Druck auf der Bedienungsseite der Berührungsfläche 10 zur Vergrößerung des sensitiven Bereichs 18 ist nicht notwendig.

### BEZUGSZIFFERNLISTE

- 10: Berührungsfeld
- 12: Oberseite von 10
- 14: Unterseite von 10
- 16: Folie
- 18: sensitiver Bereich
- 20: Leiterplatte
- 22: kapazitiver Berührungsschalter
- 24: Druckfeder
- 26: Kontaktelement zu 10
- 28: weiteres Kontaktelement zu 20
- 30: zentraler Haltestift
- 32: Rastvorrichtung von 30
- 34: Rastvorrichtung von 28
- 36: zentrales Leuchtelement
- 38: zentrales Lichtleitelement
- 40: weiteres Kontaktelement auf 20
- 42: zentraler Haltestift
- 44: Leuchtelement

## Patentansprüche

1. Kapazitiver Berührungsschalter (22), mit
einem Berührungsfeld (10) mit einer Oberseite (12) und einer Unterseite (14);
einer Leiterplatte (20), die mit einem Abstand unter der Unterseite (14) des Berührungsfeldes (10) angeordnet ist; und
einem kapazitiven Sensorelement, das zwischen der Unterseite (14) des Berührungsfeldes (10) und der Leiterplatte (20) angeordnet und mit der Leiterplatte (20) elektrisch leitend in Kontakt ist, wobei
das kapazitive Sensorelement eine Druckfeder (24) aus einem elektrisch leitenden Material und ein Kontaktelement (26) aus einem elektrisch leitenden Material, das auf der dem Berührungsfeld (10) zugewandten Seite der Druckfeder (24) angeordnet und mit der Druckfeder elektrisch leitend in Kontakt ist, aufweist und
der kapazitive Berührungsschalter (22) ferner einen zentralen Haltestift (30, 42) aufweist, der sich durch das Sensorelement im Wesentlichen über dessen gesamte Höhe erstreckt,
**dadurch gekennzeichnet,**
**dass** der Haltestift (42) integral mit dem Berührungsfeld (10) ausgebildet ist.

2. Kapazitiver Berührungsschalter nach Anspruch 1,
**dadurch gekennzeichnet,**
**dass** der Haltestift (30, 42) an seinem der Leiterplatte (20) zugewandten Ende mit einer Rastvorrichtung (32) zur mechanischen Verbindung mit der Leiterplatte (20) versehen ist.

3. Kapazitiver Berührungsschalter nach einem der Ansprüche 1 oder 2,
**dadurch gekennzeichnet,**
**dass** das kapazitive Sensorelement ferner auf seiner der Leiterplatte (20) zugewandten Seite ein weiteres Kontaktelement (28) zur elektrischen Kontaktierung mit der Leiterplatte (20) aufweist.

4. Kapazitiver Berührungsschalter nach Anspruch 1 und 3,
**dadurch gekennzeichnet,**
**dass** das weitere Kontaktelement (28) mit einer Rastvorrichtung (34) zur mechanischen Verbindung mit der Leiterplatte (20) versehen ist.

5. Kapazitiver Berührungsschalter nach Anspruch 3 oder 4,
**dadurch gekennzeichnet,**
**dass** das weitere Kontaktelement (28) und die Druckfeder (24) durch eine Lötverbindung miteinander verbunden sind.

6. Kapazitiver Berührungsschalter nach einem der Ansprüche 1 oder 2,
**dadurch gekennzeichnet,**
**dass** auf der Leiterplatte (20) ein weiteres Kontaktelement (40) zur elektrischen Kontaktierung mit der Druckfeder (24) vorgesehen ist.

7. Kapazitiver Berührungsschalter nach einem der vorherigen Ansprüche,
**dadurch gekennzeichnet,**
**dass** das Kontaktelement (26) und die Druckfeder (24) durch eine Lötverbindung miteinander verbunden sind.

8. Kapazitiver Berührungsschalter nach einem der vorhergehenden Ansprüche,
**dadurch gekennzeichnet,**
**dass** der Haltestift (42) als ein Lichtleitelement ausgebildet ist; und
**dass** auf der Leiterplatte (20) an einer mittigen Position des Sensorelements ein Leuchtelement (36) angeordnet ist.

9. Kapazitiver Berührungsschalter nach einem der Ansprüche 1 bis 7,
**dadurch gekennzeichnet,**
**dass** der Berührungsschalter ferner wenigstens ein Leuchtelement (44) neben dem kapazitiven Sensorelement zwischen der Leiterplatte (20) und dem Berührungsfeld (10) aufweist.

10. Kapazitiver Berührungsschalter nach einem der vorherigen Ansprüche,
**dadurch gekennzeichnet,**
**dass** das Berührungsfeld (10) auf seiner Oberseite (12) mit einer Folie (16) versehen ist, die an ihrer dem Berührungsfeld zugewandten Rückseite im Bereich des Kontaktelements (26) des kapazitiven Sensorelements metallisiert ist.

## Claims

1. Capacitive touch switch (22), having
a touch panel (10) having an upper side (12) and an underside (14);
a printed circuit board (20) which is arranged at a distance beneath the underside (14) of the touch panel (10); and
a capacitive sensor element which is arranged between the underside (14) of the touch panel (10) and the printed circuit board (20) and is in electrically conductive contact with the printed circuit board (20),
the capacitive sensor element having a compression spring (24) consisting of an electrically conductive material and a contact element (26) consisting of an electrically conductive material, which is arranged on that side of the compression spring (24) which faces the touch panel (10) and is in electrically conductive contact with the compression spring, and the capacitive touch switch (22) also having a central holding pin (30, 42), which extends through the sensor element essentially over its entire height,
**characterized**
**in that** the holding pin (42) is designed to be integral with the touch panel (10).

2. Capacitive touch switch according to Claim 1,
**characterized**
**in that** the holding pin (30, 42) is provided, at its end facing the printed circuit board (20), with a latching device (32) for the mechanical connection to the printed circuit board (20).

3. Capacitive touch switch according to either of Claims 1 and 2,
**characterized**
**in that** the capacitive sensor element also has, on its side facing the printed circuit board (20), a further contact element (28) for the purpose of making electrical contact with the printed circuit board (20).

4. Capacitive touch switch according to Claims 1 and 3,
**characterized**
**in that** the further contact element (28) is provided with a latching device (34) for the mechanical connection to the printed circuit board (20).

5. Capacitive touch switch according to Claim 3 or 4,
**characterized**
**in that** the further contact element (28) and the compression spring (24) are connected to one another by means of a soldered joint.

6. Capacitive touch switch according to either of Claims 1 and 2,
**characterized**
**in that** a further contact element (40) is provided on the printed circuit board (20) for the purpose of making electrical contact with the compression spring (24).

7. Capacitive touch switch according to one of the preceding claims,
**characterized**
**in that** the contact element (26) and the compression spring (24) are connected to one another by means of a soldered joint.

8. Capacitive touch switch according to one of the preceding claims,
**characterized**
**in that** the holding pin (42) is in the form of a fibreoptic element; and
**in that** a luminous element (36) is arranged on the printed circuit board (20) in a central position of the sensor element.

9. Capacitive touch switch according to one of Claims 1 to 7,
**characterized**
**in that** the touch switch also has at least one luminous element (44) in addition to the capacitive sensor element between the printed circuit board (20) and the touch panel (10).

10. Capacitive touch switch according to one of the preceding claims,
**characterized**
**in that** the touch panel (10) is provided on its upper side (12) with a foil (16), which is metal-plated on its rear side facing the touch panel in the region of the contact element (26) of the capacitive sensor element.

## Revendications

1. Détecteur tactile capacitif (22) comprenant une zone de toucher (10) dotée d'un côté supérieur (12) et d'un côté inférieur (14) ;
un circuit imprimé (20) qui est disposé à une certaine distance sous le côté inférieur (14) de la zone de toucher (10) ; et
un élément de détection capacitif qui est disposé entre le côté inférieur (14) de la zone de toucher (10) et le circuit imprimé (20) et qui est en contact électriquement conducteur avec le circuit imprimé (20),
l'élément de détection capacitif présentant un ressort de compression (24) en un matériau électriquement conducteur et un élément de contact (26) en un matériau électriquement conducteur qui est disposé sur le côté du ressort de compression (24) qui fait face à la zone de toucher (10) et qui est en contact électriquement conducteur avec le ressort de compression et
le détecteur tactile capacitif (22) présentant en plus une goupille de maintien centrale (30, 42) qui s'étend à travers l'élément de détection pour l'essentiel sur toute sa hauteur,
**caractérisé en ce**
**que** la goupille de maintien (42) fait partie intégrante de la zone de toucher (10).

2. Détecteur tactile capacitif selon la revendication 1, **caractérisé en ce que** la goupille de maintien (30, 42) est munie à son extrémité qui fait face au circuit imprimé (20) d'un dispositif à encliquetage (32) destiné à la liaison mécanique avec le circuit imprimé (20).

3. Détecteur tactile capacitif selon l'une des revendications 1 ou 2, **caractérisé en ce que** l'élément de détection capacitif présente en plus, à son extrémité qui fait face au circuit imprimé (20), un élément de contact supplémentaire (28) destiné à établir un contact électrique avec le circuit imprimé (20).

4. Détecteur tactile capacitif selon les revendications 1 et 3, **caractérisé en ce que** l'élément de contact supplémentaire (28) est muni d'un dispositif à encliquetage (34) destiné à la liaison mécanique avec le circuit imprimé (20).

5. Détecteur tactile capacitif selon la revendication 3 ou 4, **caractérisé en ce que** l'élément de contact supplémentaire (28) et le ressort de compression (24) sont reliés entre eux par une liaison brasée.

6. Détecteur tactile capacitif selon l'une des revendications 1 ou 2, **caractérisé en ce qu'**il est prévu sur le circuit imprimé (20) un élément de contact supplémentaire (40) destiné à établir un contact électrique avec le ressort de compression (24).

7. Détecteur tactile capacitif selon l'une des revendications précédentes, **caractérisé en ce que** l'élément de contact (26) et le ressort de compression (24) sont reliés entre eux par une liaison brasée.

8. Détecteur tactile capacitif selon l'une des revendications précédentes, **caractérisé en ce que** la goupille de maintien (42) est réalisée sous la forme d'un élément conducteur de lumière et qu'un élément lumineux (36) est disposé sur le circuit imprimé (20) à une position centrale de l'élément de détection.

9. Détecteur tactile capacitif selon l'une des revendications 1 à 7, **caractérisé en ce que** le détecteur tactile présente en plus au moins un élément lumineux (44) à côté de l'élément de détection capacitif entre le circuit imprimé (20) et la zone de toucher (10).

10. Détecteur tactile capacitif selon l'une des revendications précédentes, **caractérisé en ce que** la zone de toucher (10) est munie sur son côté supérieur (12) d'un film (16) qui est métallisé sur son côté arrière faisant face à la zone de toucher dans la zone de l'élément de contact (26) de l'élément de détection capacitif.
